# EUROPEAN PATENT SPECIFICATION

(11) **EP 3 869 579 B1**
(45) Date of publication and mention of the grant of the patent: **08.05.2024**
(21) Application number: 19873681.1
(22) Date of filing: 18.10.2019
(51) Int. Cl.: H03H 9/10, H01L 21/56, H03H 9/17

(54) **PACKAGING STRUCTURE AND SEMICONDUCTOR DEVICE HAVING SAME, AND ELECTRONIC APPARATUS HAVING SEMICONDUCTOR DEVICE**
VERPACKUNGSSTRUKTUR UND HALBLEITERBAUELEMENT DAMIT SOWIE ELEKTRONISCHES GERÄT MIT EINEM HALBLEITERBAUELEMENT
STRUCTURE D'ENCAPSULATION ET DISPOSITIF À SEMI-CONDUCTEUR DOTÉ DE CETTE DERNIÈRE, ET APPAREIL ÉLECTRONIQUE DOTÉ D'UN DISPOSITIF À SEMI-CONDUCTEUR

(30) Priority: 19.10.2018 CN 201811224186
(43) Date of publication of application: 25.08.2021
(73) Proprietor: Tianjin University, Tianjin 300072 (CN); Rofs Microsystem (Tianjin) Co., Ltd, Tianjin 300462 (CN)
(72) Inventor: YANG, Qingrui, Tianjin 300072 (CN); PANG, Wei, Tianjin 300072 (CN); SUN, Chongling, Tianjin 300072 (CN); ZHANG, Menglun, Tianjin 300072 (CN)
(74) Representative: Bandpay & Greuter
(86) International application number: PCT/CN2019/111927
(87) International publication number: WO 2020/078460

(56) References cited:
- CN-A- 106 876 606
- JP-A- 2004 027 404
- US-A1- 2011 115 036
- US-A1- 2012 241 216
- US-B1- 7 067 397

## Description

### Field of the Invention

Embodiments of the present disclosure relate to the packaging of semiconductor devices, and in particular to a packaging structure for a semiconductor device, a semiconductor device having the packaging structure, and an electronic device having the semiconductor device.

### Background of the Invention

In recent years, semiconductor devices based on silicon materials, especially integrated circuit chips, have achieved rapid development and have firmly occupied the mainstream position of the industry. MEMS semiconductor devices including bulk acoustic wave filters are one of the commonly used semiconductor devices at present. Generally, the MEMS devices have movable units. In order to ensure the normal operation of the MEMS devices, hollow cavity type packaging structures are required. Taking the bulk acoustic wave filter as an example, the bulk acoustic wave filter is composed of many serial resonators and parallel resonators. The core unit of the bulk acoustic wave resonator is a suspended piezoelectric film, whose lateral dimensions are mostly on the order of micrometers, and the thickness of the film is mostly on the order of nanometers. Therefore, the bulk acoustic wave filter is fragile and is very sensitive to the environment, and even water molecules in the air can interact with the surface of the semiconductor device to cause performance degradation. Therefore, it is very important to protect thin film bulk acoustic wave filters in its encapsulating.

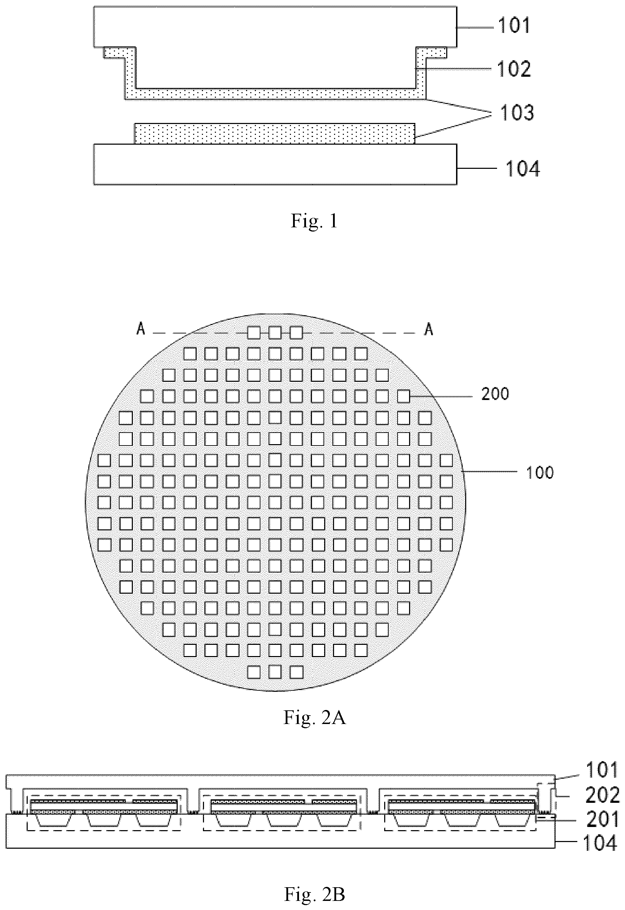

At present, a sectional view of a more commonly used sealing structure in the MEMS semiconductor device is shown in Fig. 1, a sealing ring protrusion structure 102 is processed and fabricated on a first substrate 101, a bulk acoustic wave filter is processed and fabricated on a second substrate 104, and a sealing ring of the first substrate 101 is bonded with the second substrate 104 by an adhesive layer 103 to form a sealing cavity. Due to the relatively large contact area of this sealing structure, the pressure per unit area during the bonding is relatively small, and a relatively large bonding force must be used to achieve the bonding and sealing effect, so that the process is more difficult. At the same time, this structure has poor accommodation capacity for particulate foreign matters in the adhesive layer, and it is easy to produce bonding gaps due to the introduction of the foreign matters, which leads to sealing failure. Documents US 2011/115036 A1, JP 2004 027404 A, CN 106 876 606 A, US 2012/241216 A1 and US 7 067 397 B1 are also relevant prior art in the field.

### Summary of the Invention

In order to alleviate or solve at least one aspect of the above technical problems, for example, improving the sealing effect between a packaging substrate and a chip substrate, and effectively reducing the process difficulty, the present disclosure is proposed.

Embodiments of the inventions have the features of independent claim 1.

Optionally, a plurality of connecting beams are arranged between at least a pair of adjacent sealing strips, and the plurality of connecting beams are transverse beams that vertically connect the adjacent sealing strips.

Optionally, embodiments of the invention may have the features of claim 3.

Optionally, embodiments of the invention may have the features of claim 4.

Optionally, at least one connecting beam and/or at least one sealing strip located at the middle position of the sealing part of the packaging structure is provided with a circulation structure that facilitates the flow of an adhesive material constituting the adhesive layer. Optionally, the acute angle formed between the part of the inclined beam connected with the sealing strip and the connected sealing strip is within the range of 20-70 degrees.

Optionally, the width of the sealing strip is 1-5µm, and the distance between the adjacent sealing strips is within the range of 4-30µm.

Or optionally, the protrusion height of the sealing strip is 1-3µm.

Optionally, in the aforementioned packaging structure, the adhesive layer includes a first adhesive layer, the sealing strips include a first sealing strip, the first sealing strip is arranged on the first substrate, and the first adhesive layer is arranged on the first sealing strip; and the first adhesive layer is provided with a first adhesive layer protruding strip at a position corresponding to the first sealing strip.

Further, the packaging structure further includes a sealing ring suitable for being arranged on the first substrate, and the first sealing strip protrudes from the surface of the sealing ring facing the second substrate toward the second substrate.

Optionally, the adhesive layer further includes a second adhesive layer, the second adhesive layer is suitable for being arranged on the second substrate, and the first adhesive layer protruding strip is suitable for abutting against the second adhesive layer. Further optionally, the sealing strips further include a second sealing strip, and the second sealing strip protrudes from the surface of the second substrate facing the first substrate toward the first substrate. Optionally, the second adhesive layer is provided with a second adhesive layer protruding strip at a position corresponding to the second sealing strip; and the second adhesive layer protruding strip is suitable for abutting against the first adhesive layer protruding strip. Or optionally, one side of the second adhesive layer has a shape that matches the molded surface of the second sealing strip, and the other side of the second adhesive layer is provided with a second adhesive layer protruding strip at a position corresponding to the second sealing strip, the second adhesive layer protruding strip is adapted to abut against the first adhesive layer protruding strip; or the second adhesive layer protruding strip is suitable for forming snap fit with the first adhesive layer protruding strip.

Optionally, in the packaging structure, the adhesive layer includes a second adhesive layer, the sealing strips include a second sealing strip, the second sealing strip is suitable for being arranged on the second substrate, and the second adhesive layer is arranged on the second sealing strip; and one side of the second adhesive layer has a molded surface structure that matches the shape of the second sealing strip, and the other side is provided with a second adhesive layer protruding strip at a position corresponding to the second sealing strip. Further, the adhesive layer further includes a first adhesive layer, and the first adhesive layer is suitable for being arranged on the first substrate. Furthermore, the packaging structure further includes a sealing ring suitable for being arranged on the first substrate; and the first adhesive layer is arranged on the surface of the sealing ring facing the second substrate.

In the above-mentioned packaging structure, optionally, the adhesive layer is made of gold, tungsten, molybdenum, platinum, ruthenium, iridium, germanium, copper, titanium, titanium tungsten, aluminum, chromium, arsenic-doped gold, polydimethylsiloxane or polyurethane, or alloys or combinations thereof.

Optionally, in the packaging structure, the sealing strip located on the outer side of the edge of the sealing part of the packaging structure protrudes from a base surface of the substrate on which it is arranged, and the surface roughness of the outer side face of the sealing strip on the outer side is 10-80nm, and the adhesive layer covers the outer side face. Optionally, the adhesive layer is a metal bonding layer.

The embodiments of the present disclosure further relate to a semiconductor device, including the above-mentioned packaging structure; a first substrate; and a second substrate arranged opposite to the first substrate, wherein the packaging structure is arranged between the first substrate and the second substrate, and the first substrate, the second substrate and the packaging structure are enclosed to form an accommodating space. Optionally, the semiconductor device is a bulk acoustic wave filter.

The embodiments of the present disclosure further relate to an electronic device including the above-mentioned semiconductor device.

### Brief Description of the Drawings

The following descriptions and drawings can better help understand these and other features and advantages in various embodiments disclosed in the present disclosure. The same reference sings in the drawings always indicate the same components, wherein:
Fig. 1 is a schematic diagram of a packaging structure in the prior art;
Fig. 2Ais a schematic structural diagram of a chip arranged on a substrate according to an exemplary embodiment of the present disclosure;
Fig. 2B is a schematic diagram of a partial cross section taken along the direction A-A in Fig. 2A;
Fig. 2C is a schematic diagram of a packaging structure according to an exemplary embodiment of the present disclosure;
Fig. 2D is a schematic diagram of a packaging structure according to an exemplary embodiment of the present disclosure;
Fig. 3 is a schematic diagram of a sealing strip structure (only longitudinal sealing strip);
Fig. 4 is a schematic diagram of a sealing strip structure (having a transverse beam) according to another exemplary embodiment of the present disclosure;
Fig. 5 is a schematic diagram of a sealing strip structure (having a inclined beam) according to yet another exemplary embodiment of the present disclosure;
Fig. 6A and Fig. 6B are schematic diagrams of force analysis at nodes;
Fig. 7A and Fig. 7B are schematic diagrams of a sealing strip structure (having a inclined beam and a transverse beam) according to another exemplary embodiment of the present disclosure;
Figs. 8A-8D are schematic diagrams of a sealing strip structure according to another exemplary embodiment of the present disclosure, wherein a circulation structure is provided;
Fig. 9 is a schematic diagram of a packaging structure according to an exemplary embodiment of the present disclosure;
Fig. 10 is a schematic diagram of a packaging structure according to an exemplary embodiment of the present disclosure;
Fig. 11 is a schematic diagram of a packaging structure according to an exemplary embodiment of the present disclosure.

### Detailed Description of the Embodiments

The technical solutions of the present disclosure will be further described below in detail through the embodiments and in conjunction with the drawings. In the specification, the same or similar reference signs indicate the same or similar components. The following description of the embodiments of the present disclosure with reference to the drawings is intended to explain the general inventive concept of the present disclosure, and should not be construed as a limitation to the present disclosure.

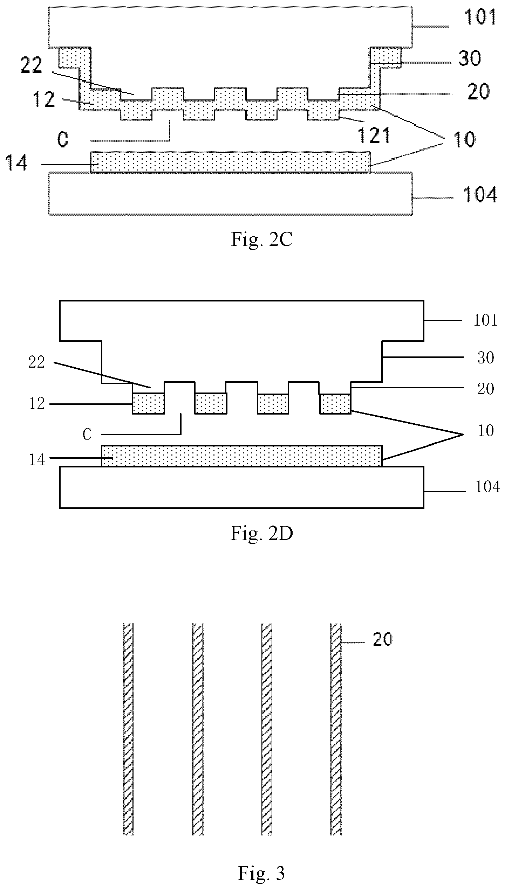

Referring to Figs. 2-11, and more specifically, for example, Figs. 2A-2D, an exemplary embodiment of the present disclosure proposes a packaging structure for a semiconductor device. As shown in Figs. 2A-2B, a plurality of chips 200 are arranged on a substrate 100, and each chip is provided with a filter 201.

As shown in Figs. 2B, 2C and 2D, the semiconductor device includes a first substrate 101 and a second substrate 104, which are opposite to each other, the packaging structure includes an adhesive layer 10 and at least two spaced apart sealing strips 20, wherein the sealing strips 20 are configured for abutting against the adhesive layer 10 by protruding toward the adhesive layer 10.

The abutment herein does not consider the state before the first substrate and the second substrate are packaged, but as long as the sealing strips squeeze the adhesive layer when the first substrate and the second substrate are packaged, the abutment is constituted.

In the solution of the present disclosure, the sealing strips protrude toward the adhesive layer and the sealing strips squeeze the adhesive layer, and there is a space allowing a sealing material or an adhesive material to enter between the sealing strips. This manner can improve the pressure at the sealing part compared with the technical solution in the prior art that there is no protruding sealing strip.

In the embodiment of the present disclosure, by disposing the protruding sealing strips, the pressure per unit area can be increased under the same bonding force, so that the package substrate and the chip substrate can be easily bonded, and the process difficulty is reduced.

It should be specially pointed out that, although in the specific example, the adhesive layers are arranged on both of the first substrate and the second substrate, the adhesive layer can also be only arranged on one substrate, and such a technical solution is also within the protection scope of the present disclosure.

In an optional embodiment, the width of the sealing strip 20 is 1-5µm such as 1µm, 5µm or 3µm and the distance between adjacent sealing strips is within the range of 1-5µm, such as 1µm, 5µm or 3µm. Further, the protrusion height of the sealing strip can be 1-3µm, for example, 1µm, 1.5µm or 3µm. On one hand, limited by the current photolithography process, the width of the sealing strip can be selected to be not less than 1um. On the other hand, limited by the current overall filter size, and in order to ensure that the bonding pressure is increased, the width of the sealing strip can be selected to be not greater than Sum. In addition, in order to ensure the strength of the sealing strip, its height can be selected to be not greater than 3um. At the same time, in order to leave a filling space for the adhesive layer metal, the height of the sealing strip can be selected to be greater than 1um.

The design structure of the sealing strip is exemplarily described below with reference to Fig. 3 to Fig. 8D.

As shown in Fig. 3, in Fig. 3, the sealing strips 20 are only a plurality of strip-shaped protrusions parallel to each other. According to needs, the number of sealing strips can be 2, 3 or more.

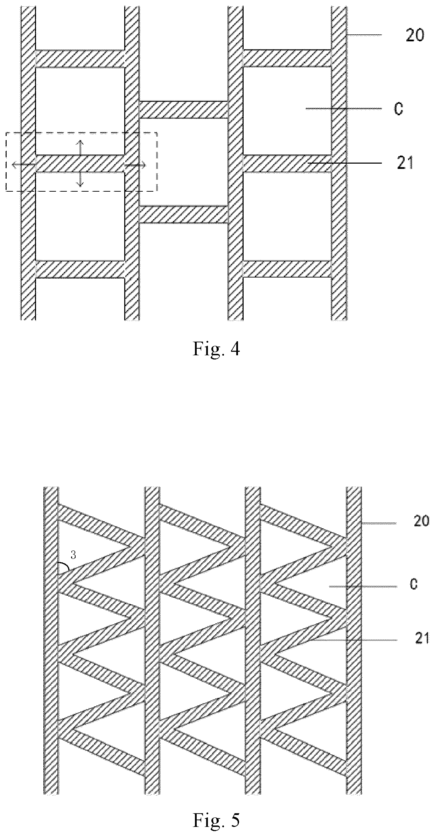

In an optional embodiment, a plurality of connecting beams 21 are arranged between at least a pair of adjacent sealing strips, and the plurality of connecting beams are transverse beams that vertically connect the adjacent sealing strips. As shown in Fig. 4, the connecting beams 21 are arranged between the adjacent sealing strips 20, and Fig. 4 shows an embodiment in which transverse beams are arranged between the adjacent sealing strips to serve as the connecting beams 21.

With respect to the design structure of the sealing strip, in the embodiment in Fig. 4, compared with the embodiment in Fig. 3, since the transverse beams are added, the contact area between the sealing strip structure and the adhesive layer is increased, which increases the adhesion force between the sealing strip structure and the adhesive layer, and further improves the sealing effect.

The transverse beams between adjacent pairs of sealing strips are arranged to be staggered to each other. In this case, as shown by the dashed frame in Fig. 4, the adhesive layer flows all around during bonding, which provides an accommodating space for particulate foreign matters. This can avoid the situation that since the both sides of a certain connecting beam are connected with connecting beams, a part of particulate foreign matters are squeezed onto the adjacent connecting beams and eventually lead to bonding gaps during the bonding, therefore the bonding effect and the sealing effect can be improved.

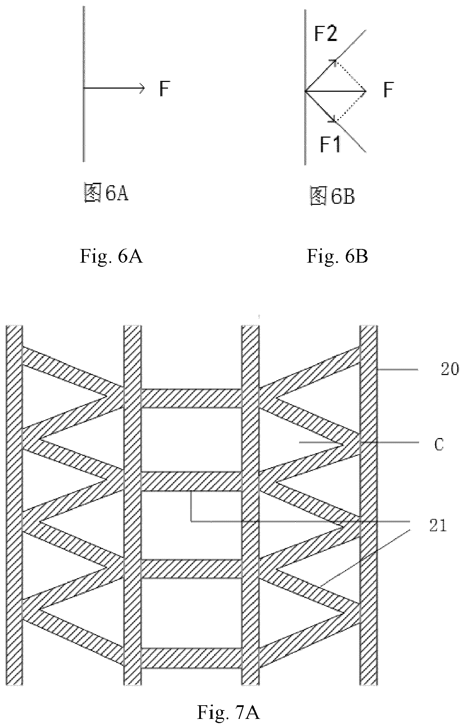

However, when an external force F is applied laterally at a "T"-shaped node of the sealing strip in Fig. 4, the force F is not dispersed or shared, as shown in Fig. 6A, so that the transverse beam bears a greater force, which easily leads to damage to the sealing strip, and the sealing effect is impaired as a result.

In order to alleviate or improve the problem of large node loss, the present disclosure further proposes the concept of arranging inclined beams between the adjacent sealing strips. The inclined beam can be considered as a connecting beam that is arranged between the adjacent sealing strips and connected to at least one sealing strip, and at least a part of which is an obliquely extending part. The inclined beams between the adjacent sealing strips are sequentially connected in a broken line shape.

In an optional embodiment, a plurality of connecting beams are arranged between at least a pair of adjacent sealing strips, and the plurality of connecting beams include inclined beams that obliquely connect the adjacent sealing strips.

Fig. 5 shows an example structure in which the inclined beams are arranged between the adjacent sealing strips.

As shown in Fig. 6B, when the applied force F is laterally applied to the node of the sealing strip, according to the orthogonal decomposition characteristics of the force, the two inclined beams share the force, so that the applied force F is decomposed into smaller forces F1 and F2, therefore the external force on the connecting beam is dispersed, and the mechanical strength and stability of the sealing structure can be effectively enhanced. Considering the problem of manufacturing process, the angle 3 between the inclined connecting beam and the sealing strip (see Fig. 5) ranges from 20-70 degrees, for example, it can be 20 degrees, 70 degrees or 45 degrees.

In addition, when the number of beams is the same and the number of sealing strips is the same, the inclined beams are longer than the transverse beams, which increases the contact area between the substance of the adhesive layer and the sealing strip and enhances the adhesion force between the adhesive layer and the sealing strip, so that the sealing effect is further improved.

As shown in Fig. 5, the connecting beams on both sides of each sealing strip having connecting beams on the both sides are arranged to be staggered to each other. In other words, on the both sides of one sealing strip, the connection points of the connecting beams and the sealing strip are different. The inclined beams between the adjacent pairs of sealing strips are arranged to be staggered to each other. In this case, the adhesive layer flows all around during bonding, which can avoid the situation that since the both sides of a certain connecting beam are connected with connecting beams, a part of particulate foreign matters are squeezed onto the adjacent connecting beams during the bonding, therefore the bonding effect can be improved.

In an optional embodiment, the packaging structure has at least four sealing strips; a plurality of connecting beams are arranged between the adjacent sealing strips at the middle position, and the plurality of connecting beams are transverse beams that vertically connect the adjacent sealing strips; and a plurality of connecting beams are arranged between the adjacent sealing strips at the edge, and the plurality of connecting beams are inclined beams that obliquely connect the adjacent sealing strips.

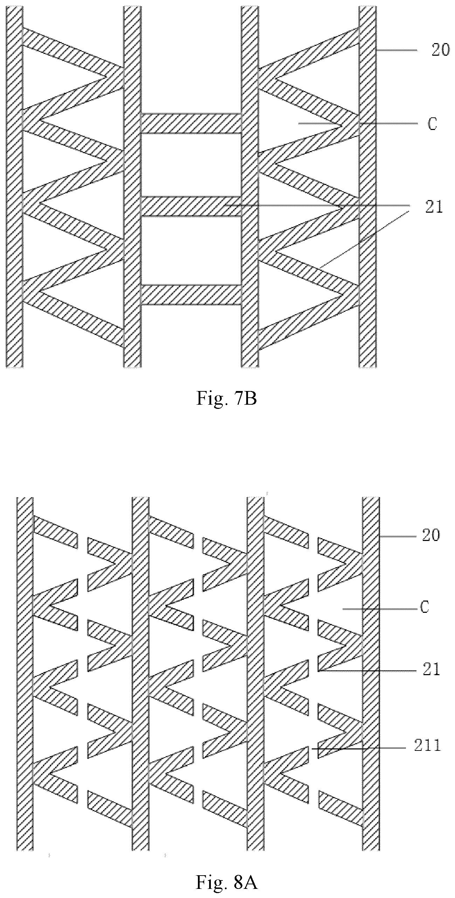

Fig. 7A shows a situation that the pair of sealing strips at the middle is provided with transverse beams, wherein the inclined beam on one side of the sealing strip and the transverse beam on the other side are connected at one point; and in Fig. 7B, the pair of sealing strips at the middle is provided with transverse beams, but the transverse beams and the inclined beams on the both sides are arranged to be staggered to each other.

It should be pointed out that, the connecting beam between the pair of sealing strips at the middle can also be in other forms, for example, a inclined beam with a different angle from the inclined beam located between the sealing strips on the edge, and these are all within the protection scope of the present disclosure.

As shown in Fig. 8A, considering the fluidity of the adhesive layer, a circulation structure 211 can be formed in the inclined beam, for example, a small hole is formed. In this way, without affecting other effects, the fluidity of the adhesive substance is enhanced, the filling effect of a sealing hollow cavity is better, the adhesion force is stronger, and the sealing stability is further enhanced. The circulation structure can be a hole or a groove or a break and the like, which is also applicable to other embodiments of the present disclosure.

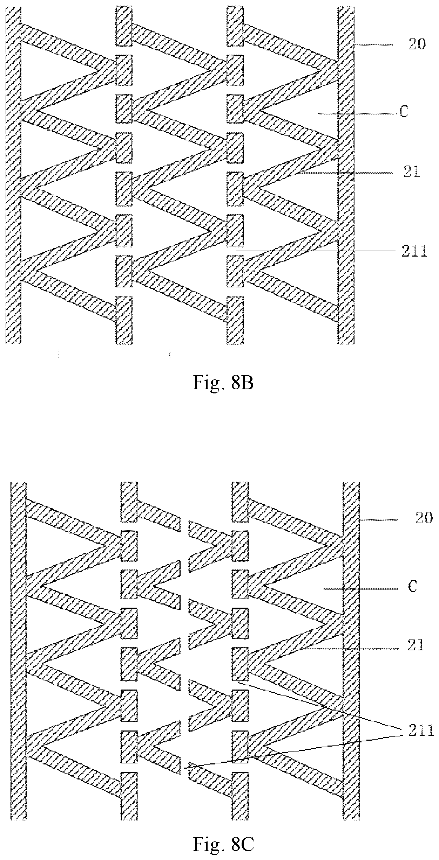

As shown in Fig. 8B, the circulation structure can be arranged to the sealing strip that is not located on the edge.

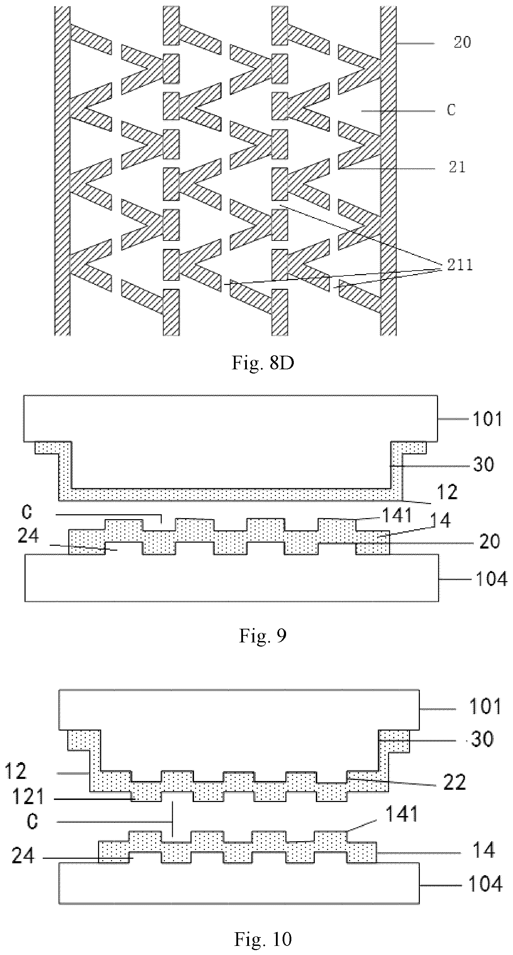

As shown in Fig. 8C and Fig. 8D, the circulation structures can also be arranged to the sealing strip that is not located on the edge and the connecting beam.

Hereinafter, the sealing strip structure of the packaging structure according to the embodiment of the present disclosure will be further described with reference to Figs. 2B-2D and Figs. 9-11.

Referring to Fig. 2B and Fig. 2C, in the packaging structure: the adhesive layer 10 includes a first adhesive layer 12, the sealing strips 20 include a first sealing strip 22, the first sealing strip 22 is arranged on the first substrate 101, and the first adhesive layer 12 is arranged on the first sealing strip 22; one side of the first adhesive layer 12 has a molded surface structure that matches the shape of the first sealing strip 22, and the other side is provided with a first adhesive layer protruding strip 121 at a position corresponding to the first sealing strip 22; the packaging structure further includes a sealing ring 30 suitable for being arranged on the first substrate 101, the first sealing strip 22 protrudes from the surface of the sealing ring 30 facing the second substrate 104 toward the second substrate 104; and the adhesive layer 10 further includes a second adhesive layer 14, the second adhesive layer 14 is suitable for being arranged on the second substrate 104, and the first adhesive layer protruding strip 121 is suitable for abutting against the second adhesive layer 14.

It needs to be specially pointed out that, when the sealing strips are arranged on one substrate, corresponding adhesive layers can be arranged on the two substrates at the same time, or the adhesive layer can be arranged on only one substrate, as long as the sealing strips can protrude to squeeze the adhesive layer to increase the pressure at the sealing part of the packaging structure. Such solutions are all within the protection scope of the present disclosure.

It should also be pointed out that, different from the situation that one side of the adhesive layer has the molded surface structure that matches the shape of the sealing strip (covering the sealing strip and the surface where the sealing strip is located) in Fig.2B and Fig. 2C, as shown in Fig. 2D, the adhesive layer covering the sealing strip can only cover the protruding surface of the sealing strip. Such an adhesive layer that only covers the sealing strip can also be applied to other embodiments of the present disclosure, for example as shown in Figs. 9-11.

For example, referring to Fig. 9, in an optional embodiment, the sealing strips include a second sealing strip 24 arranged on the substrate 104 at the bottom of the figure, the second adhesive layer 14 is also arranged on the second substrate 104, the first sealing strip is not arranged on the first substrate 101, but the first adhesive layer 12 is provided to the first substrate 101. More specifically, the adhesive layer includes the second adhesive layer 14, the sealing strips include the second sealing strip 24, the second sealing strip 24 is suitable for being arranged on the second substrate 104, and the second adhesive layer 14 is arranged on the second sealing strip 24; and one side of the second adhesive layer 14 has a molded surface structure that matches the shape of the second sealing strip, and the other side is provided with a second adhesive layer protruding strip 141 at a position corresponding to the second sealing strip. Further, as shown in Fig. 9, the adhesive layer further includes the first adhesive layer 12, and the first adhesive layer 12 is suitable for being arranged on the first substrate 101. Furthermore, as shown in Fig. 9, the packaging structure further includes the sealing ring 30 suitable for being arranged on the first substrate; and the first adhesive layer 12 is arranged on the surface of the sealing ring 30 facing the second substrate 104. Although not shown, in an optional embodiment, the first adhesive layer 12 in Fig. 9 may not be provided.

It should also be pointed out that, although in the drawings, the sides of the adhesive layers that cover the sealing strips facing the sealing strips are all provided with the adhesive layer protruding strips, the adhesive layer protruding strips may not be provided. Such solutions are also within the protection scope of the present disclosure.

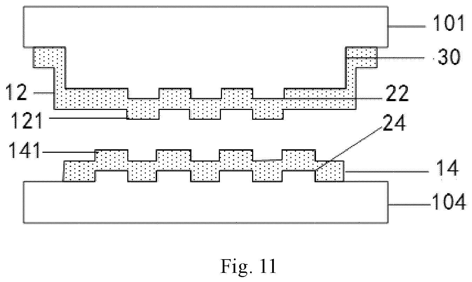

In the example shown in Fig. 10 and Fig. 11, the sealing strip 20 includes the second sealing strip 24 in addition to the first sealing strip 22, and the second sealing strip 24 protrudes from the surface of the second substrate 104 facing the first substrate 101 toward the first substrate 101. The adhesive layer also includes the first adhesive layer 12 and the second adhesive layer 14.

As shown in Fig. 10, in an exemplary packaging structure, one side of the second adhesive layer 14 has a shape that matches the molded surface of the second sealing strip 24, and the other side of the second adhesive layer 14 is provided with the second adhesive layer protruding strip 141 at the position corresponding to the second sealing strip; and the second adhesive layer protruding strip 141 is suitable for abutting against the first adhesive layer protruding strip 121. In the example shown in Fig. 10, the first sealing strip and the second sealing strip are opposite to each other.

As shown in Fig. 11, in an exemplary packaging structure, one side of the second adhesive layer 14 has a shape that matches the molded surface of the second sealing strip 24, and the other side of the second adhesive layer 14 is provided with the second adhesive layer protruding strip 141 at the position corresponding to the second sealing strip; and the second adhesive layer protruding strip 141 is suitable for forming snap fit with the first adhesive layer protruding strip 121. In the example shown in Fig. 11, the first sealing strip is in snap fit with the second sealing strip.

In an optional embodiment, the adhesive layer is made of gold, tungsten, molybdenum, platinum, ruthenium, iridium, germanium, copper, titanium, titanium tungsten, aluminum, chromium, arsenic-doped gold, polydimethylsiloxane or polyurethane, or alloys or combinations thereof.

Optionally, in the packaging structure, the sealing strip located on the outer side of the edge of the sealing part of the packaging structure protrudes from a base surface of the substrate on which it is arranged, and the surface roughness of the outer side face of the sealing strip on the outer side is 10-80nm, and the adhesive layer covers the outer side face. The surface roughness of the substrate caused by the current etching process can be selected to be greater than 10nm. In addition, the adhesion force of the adhesive layer to the surface of the substrate can be improved by appropriately increasing the surface roughness. However, when the surface roughness is greater than 80nm, the adhesion force will decrease, therefore, the surface roughness can be selected to be not greater than 80nm. Optionally, the adhesive layer is a metal bonding layer. This choice of surface roughness can help reduce the possibility of the adhesive layer falling off from the substrate or the sealing strip on the outer side.

The packaging structure of the present disclosure can be applied to the packaging of semiconductor devices, for example the packaging of radio frequency filters, and can also be used in other MEMS component packaging structures. Although not shown, the embodiment of the present disclosure further relates to a semiconductor device, including the above-mentioned packaging structure; a first substrate; and a second substrate arranged opposite to the first substrate, wherein the packaging structure is arranged between the first substrate and the second substrate, and the first substrate, the second substrate and the packaging structure are enclosed to form an accommodating space. Optionally, the semiconductor device is a bulk acoustic wave filter.

Although not shown, the embodiment of the present disclosure further relates to an electronic device, including the above-mentioned semiconductor device.

## Claims

1. A packaging structure for a semiconductor device that comprises a first substrate and a second substrate which are opposite to each other, wherein the packaging structure comprises:
an adhesive layer (10); and
at least two spaced apart sealing strips (20),
wherein:
the sealing strips (20) being configured for abutting against the adhesive layer (10) by protruding toward the adhesive layer (10);
wherein a plurality of connecting beams are arranged between at least a pair of adjacent sealing strips (20), each connecting beam comprising respective connection points, the connecting beams on both sides of each sealing strip having connecting beams of the same structure on the both sides are arranged to be staggered to each other so that, on the both sides of one sealing strip, the respective connection points of the connecting beams and the sealing strip are different.

2. The packaging structure according to claim 1, wherein:
a plurality of connecting beams are arranged between at least a pair of adjacent sealing strips (20), and the plurality of connecting beams are transverse beams that vertically connect the adjacent sealing strips (20).

3. The packaging structure according to claim 1, wherein:
a plurality of connecting beams, each connecting beam comprising respective connection points, arranged between at least a pair of adjacent sealing strips (20), and the plurality of connecting beams are inclined beams, each connecting beam having a connection point with a respective sealing strip of the pair of adjacent sealing strips (20) and having an oblique angle with respect to the respective adjacent sealing strips (20), further alternatively, the inclined beams between the adjacent sealing strips (20) are sequentially connected in a broken line shape.

4. The packaging structure according to claim 1, wherein:
the packaging structure has at least four sealing strips (20);
a plurality of connecting beams are arranged between the adjacent sealing strips (20) at the middle position of a sealing part of the packaging structure, and the plurality of connecting beams are inclined beams or the plurality of connecting beams are transverse beams that vertically connect the adjacent sealing strips (20); and
a plurality of connecting beams, each connecting beam comprising respective connection points, arranged between the adjacent sealing strips (20) at the edge of the sealing part of the packaging structure, and the plurality of connecting beams are inclined beams, each connecting beam having a connection point with a respective sealing strip of the pair of adjacent sealing strips (20) and having an oblique angle with respect to the respective adjacent sealing strips (20),
further alternatively, the inclined beams between the adjacent sealing strips (20) at the edge of the sealing part of the packaging structure are sequentially connected in a broken line shape.

5. The packaging structure according to claim 4, wherein:
the connecting beams, on the both sides of each sealing strip having connecting beams with different structures on the both sides, are arranged to be staggered to each other; or
the connecting beams, on the both sides of each sealing strip having connecting beams with different structures and different angles with the sealing strips (20) on the both sides, have the same connection point.

6. The packaging structure according to any one of claims 2-5, wherein:
at least one connecting beam and/or at least one sealing strip located at the middle position of the sealing part of the packaging structure is provided with a circulation structure that facilitates the flow of an adhesive material constituting the adhesive layer (10).

7. The packaging structure according to any one of claims 1-6, wherein:
the adhesive layer (10) comprises a first adhesive layer, the sealing strips (20) comprise a first sealing strip, the first sealing strip is arranged on the first substrate, and the first adhesive layer is arranged on the first sealing strip; and
the first adhesive layer is provided with a first adhesive layer protruding strip at a position corresponding to the first sealing strip.

8. The packaging structure according to claim 7, wherein:
the packaging structure further comprises a sealing ring suitable for being arranged on the first substrate, and the first sealing strip protrudes from the surface of the sealing ring facing the second substrate toward the second substrate.

9. The packaging structure according to claim 7 or 8, wherein:
the adhesive layer (10) further comprises a second adhesive layer, the second adhesive layer is suitable for being arranged on the second substrate, and the first adhesive layer protruding strip is suitable for abutting against the second adhesive layer.

10. The packaging structure according to claim 9, wherein:
the sealing strips (20) further comprise a second sealing strip, and the second sealing strip protrudes from the surface of the second substrate facing the first substrate toward the first substrate,
further alternatively,
one side of the second adhesive layer has a shape that matches the molded surface of the second sealing strip, the other side of the second adhesive layer is provided with a second adhesive layer protruding strip at a position corresponding to the second sealing strip, and the second adhesive layer protruding strip is suitable for abutting against the first adhesive layer protruding strip; or the second adhesive layer protruding strip is suitable for forming snap fit with the first adhesive layer protruding strip.

11. The packaging structure according to any one of claims 1-7, wherein:
the adhesive layer (10) comprises a second adhesive layer, the sealing strips (20) comprise a second sealing strip, the second sealing strip is suitable for being arranged on the second substrate, and the second adhesive layer is arranged on the second sealing strip; and
the second adhesive layer is provided with a second adhesive layer protruding strip at a position corresponding to the second sealing strip.

12. The packaging structure according to any one of claims 1-11, wherein:
the sealing strip located on the outer side of the edge of the sealing part of the packaging structure protrudes from a base surface of the substrate on which it is arranged, and the surface roughness of the outer side face of the sealing strip on the outer side is 10-80nm, and the adhesive layer (10) covers the outer side face, further alternatively, the adhesive layer (10) is a metal bonding layer.

13. A semiconductor device, comprising:
the packaging structure according to any one of claims 1-12;
a first substrate; and
a second substrate arranged opposite to the first substrate,
wherein:
the packaging structure is arranged between the first substrate and the second substrate, and the first substrate, the second substrate and the packaging structure are enclosed to form an accommodating space.

14. An electronic device, comprising the semiconductor device according to claim 13.

## Patentansprüche

1. Gehäusestruktur für eine Halbleitervorrichtung, die ein erstes Substrat und ein zweites Substrat umfasst, die einander gegenüber sind, wobei die Gehäusestruktur Folgendes umfasst:
eine Klebeschicht (10) und
mindestens zwei beabstandete Dichtungsstreifen (20),
wobei:
wobei die Dichtungsstreifen (20) konstruiert sind, um an der Klebeschicht (10) anzuliegen, indem sie in Richtung der Klebeschicht (10) hervorstehen;
wobei eine Vielzahl von Verbindungsbalken zwischen mindestens einem Paar angrenzender Dichtungsstreifen (20) angeordnet ist, jeder Verbindungsbalken umfassend entsprechende Verbindungspunkte, wobei die Verbindungsbalken auf beiden Seiten von jedem Dichtungsstreifen, die Verbindungsbalken der gleichen Struktur auf den beiden Seiten aufweisen, angeordnet sind, um zueinander versetzt zu sein, sodass auf den beiden Seiten eines Dichtungsstreifens die entsprechenden Verbindungspunkte der Verbindungsbalken und des Dichtungsstreifens verschieden sind.

2. Gehäusestruktur nach Anspruch 1, wobei:
eine Vielzahl von Verbindungsbalken zwischen mindestens einem Paar angrenzender Dichtungsstreifen (20) angeordnet sind, und die Vielzahl von Verbindungsbalken Querbalken sind, die die angrenzenden Dichtungsstreifen (20) vertikal verbinden.

3. Gehäusestruktur nach Anspruch 1, wobei:
eine Vielzahl von Verbindungsbalken, wobei jeder Verbindungsbalken jeweilige Verbindungspunkte umfasst, die zwischen mindestens einem Paar angrenzender Dichtungsstreifen (20) angeordnet sind, und die Vielzahl von Verbindungsbalken geneigte Balken sind, wobei jeder Verbindungsbalken einen Verbindungspunkt mit einem jeweiligen Dichtungsstreifen des Paars angrenzender Dichtungsstreifen (20) aufweist und einen schrägen Winkel in Bezug auf die jeweiligen angrenzenden Dichtungsstreifen (20) aufweist, wobei ferner alternativ die geneigten Balken zwischen den angrenzenden Dichtungsstreifen (20) aufeinanderfolgend in einer unterbrochenen Linienform verbunden sind.

4. Gehäusestruktur nach Anspruch 1, wobei:
die Gehäusestruktur mindestens vier Dichtungsstreifen (20) aufweist;
eine Vielzahl von Verbindungsbalken zwischen den angrenzenden Dichtungsstreifen (20) an der mittleren Position eines Dichtungsteils der Gehäusestruktur angeordnet sind, und die Vielzahl von Verbindungsbalken Schrägbalken sind oder die Vielzahl von Verbindungsbalken Querbalken sind, die die angrenzenden Dichtungsstreifen (20) vertikal verbinden; und
eine Vielzahl von Verbindungsbalken, wobei jeder Verbindungsbalken entsprechende Verbindungspunkte aufweist, die zwischen den angrenzenden Dichtungsstreifen (20) an dem Rand des Dichtungsteils der Gehäusestruktur angeordnet sind, und die Vielzahl von Verbindungsbalken geneigte Balken sind, wobei jeder Verbindungsbalken einen Verbindungspunkt mit einem jeweiligen Dichtungsstreifen des Paars angrenzender Dichtungsstreifen (20) aufweist und einen schrägen Winkel in Bezug auf die jeweiligen angrenzenden Dichtungsstreifen (20) aufweist,
wobei ferner alternativ die geneigten Balken zwischen den angrenzenden Dichtungsstreifen (20) an dem Rand des Dichtungsteils der Gehäusestruktur aufeinanderfolgend in einer unterbrochenen Linienform verbunden sind.

5. Gehäusestruktur nach Anspruch 4, wobei:
die Verbindungsbalken auf den beiden Seiten von jedem Dichtungsstreifen, die auf beiden Seiten unterschiedlich strukturierte Verbindungsbalken aufweisen, zueinander versetzt angeordnet sind; oder
die Verbindungsbalken auf beiden Seiten von jedem Dichtungsstreifen, die Verbindungsbalken mit unterschiedlichen Strukturen und unterschiedlichen Winkeln mit den Dichtungsstreifen (20) auf beiden Seiten aufweisen, denselben Verbindungspunkt aufweisen.

6. Gehäusestruktur nach einem der Ansprüche 2-5, wobei:
mindestens ein Verbindungsbalken und/oder mindestens ein Dichtungsstreifen, der sich in der mittleren Position des Dichtungsteils der Gehäusestruktur befindet, mit einer Zirkulationsstruktur versehen ist, die das Fließen eines Klebstoffmaterials ermöglicht, das die Klebeschicht (10) bildet.

7. Gehäusestruktur nach einem der Ansprüche 1-6, wobei:
die Klebeschicht (10) eine erste Klebeschicht umfasst, die Dichtungsstreifen (20) einen ersten Dichtungsstreifen umfassen, der erste Dichtungsstreifen auf dem ersten Substrat angeordnet ist, und die erste Klebeschicht auf dem ersten Dichtungsstreifen angeordnet ist; und
die erste Klebeschicht an einer Position mit einem ersten Klebeschicht-Vorsprungstreifen versehen ist, die dem ersten Dichtungsstreifen entspricht.

8. Gehäusestruktur nach Anspruch 7, wobei:
die Gehäusestruktur ferner einen Dichtungsring umfasst, der geeignet ist, um auf dem ersten Substrat angeordnet zu werden, und der erste Dichtungsstreifen von der Oberfläche des Dichtungsrings, die dem zweiten Substrat zugewandt ist, in Richtung des zweiten Substrats hervorsteht.

9. Gehäusestruktur nach Anspruch 7 oder 8, wobei:
die Klebeschicht (10) ferner eine zweite Klebeschicht umfasst, die zweite Klebeschicht geeignet ist, auf dem zweiten Substrat angeordnet zu werden, und der aus der ersten Klebeschicht hervorstehende Streifen geeignet ist, um an der zweiten Klebeschicht anzuliegen.

10. Gehäusestruktur nach Anspruch 9, wobei:
die Dichtungsstreifen (20) ferner einen zweiten Dichtungsstreifen umfassen, und der zweite Dichtungsstreifen von der Oberfläche des zweiten Substrats, die dem ersten Substrat zugewandt ist, in Richtung des ersten Substrats hervorsteht,
ferner alternativ,
eine Seite der zweiten Klebeschicht eine Form aufweist, die mit der geformten Oberfläche des zweiten Dichtungsstreifens übereinstimmt, die andere Seite der zweiten Klebeschicht an einer Position mit einem zweiten Klebeschicht-Vorsprungsstreifen versehen ist, die dem zweiten Dichtungsstreifen entspricht, und der zweite Klebeschicht-Vorsprungsstreifen geeignet ist, um an dem ersten Klebeschicht-Vorsprungsstreifen anzuliegen, oder der zweite Klebeschicht-Vorsprungsstreifen geeignet ist, um mit dem ersten Klebeschicht-Vorsprungsstreifen eine Rastverbindung zu bilden.

11. Gehäusestruktur nach einem der Ansprüche 1-7, wobei:
die Klebeschicht (10) eine zweite Klebeschicht umfasst, die Dichtungsstreifen (20) einen zweiten Dichtungsstreifen umfassen, der zweite Dichtungsstreifen geeignet ist, um auf dem zweiten Substrat angeordnet zu werden, und die zweite Klebeschicht auf dem zweiten Dichtungsstreifen angeordnet ist; und
die zweite Klebeschicht an einer Position, die dem zweiten Dichtungsstreifen entspricht, mit einem zweiten Klebeschicht-Vorsprungstreifen versehen ist.

12. Gehäusestruktur nach einem der Ansprüche 1-11, wobei:
der Dichtungsstreifen, der sich auf der Außenseite des Rands des Dichtungsteils der Gehäusestruktur befindet, von einer Grundfläche des Substrats hervorsteht, auf dem er angeordnet ist, und die Oberflächenrauhigkeit der Außenseitenfläche des Dichtungsstreifens auf der Außenseite 10-80 nm ist, und die Klebeschicht (10) die Außenseitenfläche bedeckt, ferner alternativ die Klebeschicht (10) eine Metallbindungsschicht ist.

13. Halbleitervorrichtung, umfassend:
die Gehäusestruktur nach einem der Ansprüche 1-12;
ein erstes Substrat; und
ein zweites Substrat, das gegenüber dem ersten Substrat angeordnet ist, wobei:
die Gehäusestruktur zwischen dem ersten Substrat und dem zweiten Substrat angeordnet ist, und das erste Substrat, das zweite Substrat und die Gehäusestruktur umschlossen sind, um einen Aufnahmeraum zu bilden.

14. Elektronische Vorrichtung, umfassend die Halbleitervorrichtung nach Anspruch 13.

## Revendications

1. Structure d'encapsulation destinée à un dispositif à semi-conducteurs qui comprend un premier substrat et un deuxième substrat qui sont opposés l'un à l'autre, dans laquelle la structure d'encapsulation comprend :
une couche adhésive (10) ; et
au moins deux bandes de scellement espacées (20),
dans laquelle :
les bandes de scellement (20) sont configurées pour buter contre la couche adhésive (10) en dépassant vers la couche adhésive (10) ;
dans laquelle plusieurs barres de liaison sont prévues entre au moins une paire de bandes de scellement adjacentes (20), chaque barre de liaison comprenant des points de liaison respectifs, les barres de liaison des deux côtés de chaque bande de scellement étant prévues pour être décalées les unes par rapport aux autres de sorte que, des deux côtés d'une bande de scellement, les points de liaison respectifs des barres de liaison et de la bande de scellement soient différents.

2. Structure d'encapsulation selon la revendication 1, dans laquelle :
plusieurs barres de liaison sont prévues entre au moins une paire de bandes de scellement adjacentes (20), et les barres de liaison sont des barres transversales qui relient verticalement les bandes de scellement adjacentes (20).

3. Structure d'encapsulation selon la revendication 1, dans laquelle :
une pluralité de barres de liaison, chaque barre de liaison comprenant des points de liaison respectifs, prévues entre au moins une paire de bandes de scellement adjacentes (20), et la pluralité de barres de liaison sont des barres inclinées, chaque barre de liaison ayant un point de liaison avec une bande de scellement respective de la paire de bandes de scellement adjacentes (20) et présentant un angle oblique par rapport aux bandes de scellement adjacentes respectives (20), et, en variante, les barres inclinées entre les bandes de scellement adjacentes (20) étant reliées successivement en forme de ligne discontinue.

4. Structure d'encapsulation selon la revendication 1, dans laquelle :
la structure d'encapsulation possède au moins quatre bandes de scellement (20) ;
plusieurs barres de liaison sont prévues entre les bandes de scellement adjacentes (20) au milieu d'une partie de scellement de la structure d'encapsulation, et les barres de liaison sont des barres inclinées ou les barres de liaison sont des barres transversales qui relient verticalement les bandes de scellement adjacentes (20) ; et
plusieurs barres de liaison, chaque barre de liaison comprenant des points de liaison respectifs, prévues entre les bandes de scellement adjacentes (20) au niveau du bord de la partie de scellement de la structure d'encapsulation, et la pluralité de barres de liaison sont des barres inclinées, chaque barre de liaison ayant un point de liaison avec une bande de scellement respective de la paire de bandes de scellement adjacentes (20) et présentant un angle oblique par rapport aux bandes de scellement adjacentes respectives (20),
en variante, les barres inclinées entre les bandes de scellement adjacentes (20) au niveau du bord de la partie de scellement de la structure d'encapsulation sont successivement reliées en forme de ligne discontinue.

5. Structure d'encapsulation selon la revendication 4, dans laquelle :
les barres de liaison, des deux côtés de chaque bande de scellement ayant des barres de liaison avec différentes structures des deux côtés, sont prévues pour être décalées les unes par rapport aux autres ; ou
les barres de liaison, des deux côtés de chaque bande de scellement ayant des barres de liaison avec différentes structures et différents angles avec les barres de scellement (20) des deux côtés, possèdent le même point de liaison.

6. Structure d'encapsulation selon l'une quelconque des revendications 2 à 5, dans laquelle :
au moins une barre de liaison et/ou au moins une bande de scellement qui se trouve au milieu de la partie de scellement de la structure d'encapsulation est équipée d'une structure de circulation qui facilite la circulation d'un matériau adhésif qui constitue la couche adhésive (10).

7. Structure d'encapsulation selon l'une quelconque des revendications 1 à 6, dans laquelle :
la couche adhésive (10) comprend une première couche adhésive, les bandes de scellement (20) comprennent une première bande de scellement, la première bande de scellement est prévue sur le premier substrat, et la première couche adhésive est prévue sur la première bande de scellement ; et
la première couche adhésive est munie d'une bande en saillie de première couche adhésive à un emplacement qui correspond à la première bande de scellement.

8. Structure d'encapsulation selon la revendication 7, dans laquelle :
la structure d'encapsulation comprend en outre une bague d'étanchéité qui peut être placée sur le premier substrat, et la première bande de scellement dépasse de la surface de la bague d'étanchéité qui fait face au deuxième substrat vers le deuxième substrat.

9. Structure d'encapsulation selon la revendication 7 ou 8, dans laquelle :
la couche adhésive (10) comprend en outre une deuxième couche adhésive, la deuxième couche adhésive est adaptée pour être placée sur le deuxième substrat, et la bande en saillie de première couche adhésive est adaptée pour buter contre la deuxième couche adhésive.

10. Structure d'encapsulation selon la revendication 9, dans laquelle :
les bandes de scellement (20) comprennent en outre une deuxième bande de scellement, et la deuxième bande de scellement dépasse de la surface du deuxième substrat qui fait face au premier substrat vers le premier substrat,
en outre, en variante,
un côté de la deuxième couche adhésive possède une forme qui correspond à la surface moulée de la deuxième bande de scellement, l'autre côté de la deuxième couche adhésive est muni d'une bande en saillie de deuxième couche adhésive à un emplacement qui correspond à la deuxième bande de scellement, et la bande en saillie de deuxième couche adhésive peut buter contre la bande en saillie de première couche adhésive ; ou la bande en saillie de deuxième couche adhésive peut former un encliquetage avec la bande en saillie de première couche adhésive.

11. Structure d'encapsulation selon l'une quelconque des revendications 1 à 7, dans laquelle :
la couche adhésive (10) comprend une deuxième couche adhésive, les bandes de scellement (20) comprennent une deuxième bande de scellement, la deuxième bande de scellement peut être placée sur le deuxième substrat, et la deuxième couche adhésive est placée sur la deuxième bande de scellement ;
et
la deuxième couche adhésive est munie d'une bande en saillie de deuxième couche adhésive à un emplacement qui correspond à la deuxième bande de scellement.

12. Structure d'encapsulation selon l'une quelconque des revendications 1 à 11, dans laquelle :
la bande de scellement qui se trouve sur le côté externe du bord de la partie de scellement de la structure d'encapsulation dépasse d'une surface de base du substrat sur laquelle elle est prévue, et la rugosité de surface de la face externe de la bande de scellement sur le côté externe est de 10 à 80 nm, et la couche adhésive (10) recouvre la face externe, et, en variante, la couche adhésive (10) est une couche de liaison métallique.

13. Dispositif à semi-conducteurs, comprenant :
la structure d'encapsulation selon l'une quelconque des revendications 1 à 12 ;
un premier substrat ; et
un deuxième substrat opposé au premier substrat,
dans lequel :
la structure d'encapsulation est prévue entre le premier substrat et le deuxième substrat, et le premier substrat, le deuxième substrat et la structure d'encapsulation sont enfermés afin de former un espace d'accueil.

14. Dispositif électronique, comprenant le dispositif à semi-conducteurs selon la revendication 13.
